# FASCICULE DE BREVET EUROPEEN

(11) **EP 2 092 643 B1**
(45) Date de publication et mention de la délivrance du brevet: **12.03.2014**
(21) Numéro de dépôt: 07823853.2
(22) Date de dépôt: 26.09.2007
(51) Int. Cl.: H03K 17/06, H02M 7/217

(54) **ELEMENT DE PONT REDRESSEUR SYNCHRONE, PONT REDRESSEUR SYNCHRONE CORRESPONDANT ET UTILISATION**
GLIED FÜR EINE SYNCHRON-GLEICHRICHTERBRÜCKE, DIESBEZÜGLICHE SYNCHRON-GLEICHRICHTERBRÜCKE UND VERWENDUNG DAFÜR
MEMBER FOR A SYNCHRONOUS RECTIFIER BRIDGE, RELATED SYNCHRONOUS RECTIFIER BRIDGE AND USE THEREOF

(30) Priorité: 16.11.2006 FR 0654927
(43) Date de publication de la demande: 26.08.2009
(73) Titulaire: Valeo Equipements Electriques Moteur, 94046 Créteil Cedex (FR)
(72) Inventeur: MASSON, Philippe, 77166 Grisy-Suisnes (FR); BLONDEL, Gaël, 94370 Sucy-en-Brie (FR)
(86) Numéro de dépôt international: PCT/FR2007/052008
(87) Numéro de publication internationale: WO 2008/059145

(56) Documents cités:
- EP-A- 1 133 048
- WO-A2-2004/034439
- FR-A- 2 884 079
- US-A1- 2002 141 214
- US-A1- 2003 151 432

## Description

### DOMAINE TECHNIQUE DE L'INVENTION

La présente invention concerne un élément de pont redresseur synchrone, notamment un bras de pont, ainsi qu'un pont redresseur de tension comportant une pluralité de cet élément.

L'invention concerne aussi une machine électrique tournante utilisant ce même pont redresseur.

### ARRIERE PLAN TECHNOLOGIQUE DE L'INVENTION

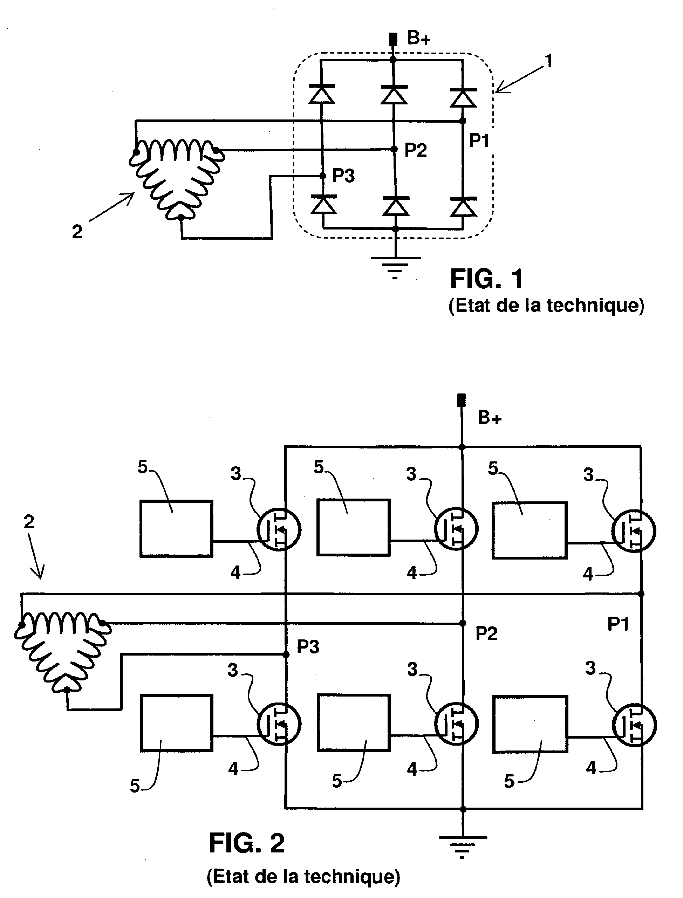

Les ponts redresseurs à diodes, tels que celui représenté sur la Figure 1, sont bien connus de l'état de la technique.

Les diodes utilisées dans ce type de ponts redresseurs, que ce soit des diodes à jonction, PIN, ou Schottky, présentent une chute de tension dans le sens passant non négligeable en basse tension.

Cela représente un inconvénient dans le domaine des équipements automobiles qui travaillent en basse tension. Par exemple, rendement électrique d'un alternateur est dégradé de ce fait.

Afin d'améliorer le rendement global des équipements électriques mettant en oeuvre des ponts de diodes, il est connu d'utiliser des redresseurs synchrones à interrupteurs (transistors, thyristors, tracs,...).

Le document EP1347564 décrit un pont redresseur synchrone triphasé de ce type, dont le schéma de principe est repris sur la Figure 2.

Les grilles des transistors de type MOSFET canal N (transistor à effet de champ à grille isolée) ou IGBT (transistor bipolaire à porte isolée) fonctionnant en commutation sont contrôlées en fonction de la valeur absolue des différences de tensions entre phases afin de produire, en sortie du pont, une tension continue.

Il est aussi connu du document W02004/034439 de piloter les MOSFETs en mode linéaire dans l'état passant, c'est-à-dire de piloter linéairement leur résistance interne au moyen d'un asservissement de manière à simuler le comportement de diodes idéales.

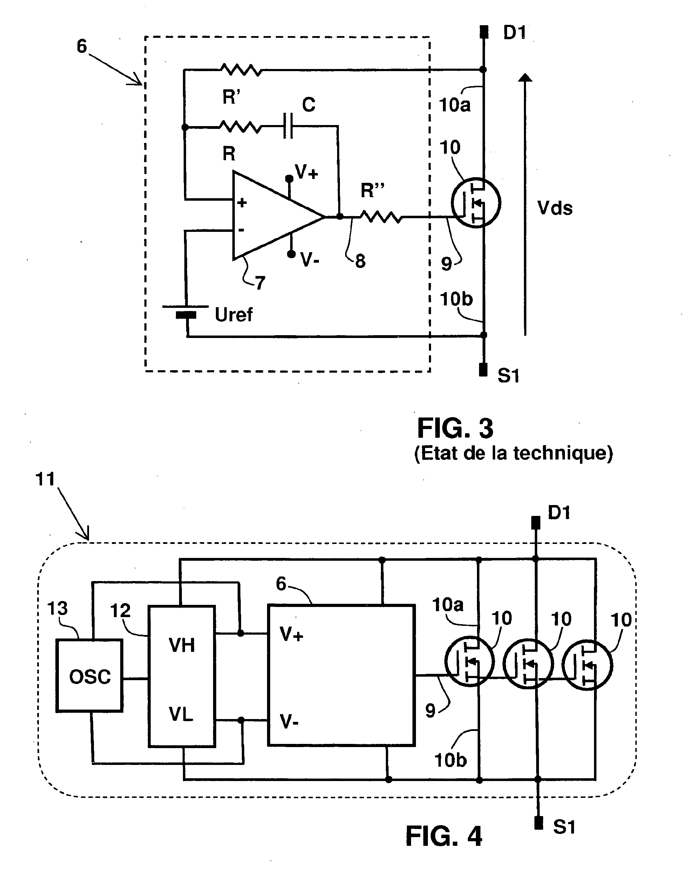

Dans le document FR2884079, la société VALEO EQUIPEMENTS ELECTRIQUES MOTEUR divulgue un procédé de commande d'un transistor MOS, destiné à être mis en oeuvre dans un pont de conversion électrique (onduleur, ou redresseur), dans le but de pallier l'accumulation des charges électriques dans le transistor responsable du retard à la commutation, qui engendre un important courant de recouvrement. Le schéma de principe du dispositif correspondant est donné sur la Figure 3.

Les développements techniques rappelés ci-dessus ont conduit à une optimisation du rendement des redresseurs synchrones.

Le document US 2002/0141214 decrit un élément de pont redresseur synchrone connu, qui correspond au préambule de la revendication 1.

Toutefois, les redresseurs synchrones connus nécessitent un circuit d'alimentation et de commande supplémentaire, et ne permettent pas de désactiver le redressement synchrone si la tension aux bornes du pont redresseur ne suffis pas à assurer une commande correcte des transistors.

### DESCRIPTION GENERALE DE L'INVENTION

La présente invention vise donc à intégrer avec les composants de puissance leur alimentation et leur commande dans un boîtier unique, de manière à rendre possible l'utilisation d'un élément de pont redresseur synchrone en lieu et place d'une ou de plusieurs diodes.

Elle concerne précisément un élément de pont redresseur synchrone présentant au moins une première borne de raccordement, et au moins une deuxième borne de raccordement.

Cet élément est du type de ceux connus en soi comprenant au moins un premier transistor à effet de champ, dont la première source et le premier drain sont reliés respectivement aux première et deuxième bornes de raccordement, et au moins un premier amplificateur opérationnel comportant une première boucle de contre-réaction, dont la première sortie est reliée à la première grille du premier transistor.

Cet amplificateur est monté en comparateur d'au moins une première source de tension ayant une tension de référence prédéterminée et d'au moins une première différence de tension entre des tensions appliquées aux première et deuxième bornes de raccordement.

L'élément de pont redresseur synchrone selon l'invention est remarquable en ce qu'il comporte de plus une pompe de charges produisant au moins l'une des tensions d'alimentation du premier amplificateur à partir des tensions appliquées aux bornes de raccordement.

L'élément de pont redresseur synchrone selon l'invention comprend avantageusement un circuit de mise en veille de la pompe de charges quand la fréquence ou l'amplitude moyenne d'au moins l'une des tensions appliquées est inférieure à une valeur prédéterminée.

De préférence, la pompe de charges est commandée par un oscillateur alimenté par la pompe de charge elle-même.

Selon l'invention, on tirera bénéfice d'un élément de pont redresseur synchrone comprenant au moins un second transistor à effet de champ dont la seconde source et le seconde drain sont reliés respectivement à la deuxième borne de raccordement et à une troisième borne de raccordement, et comprenant de plus un second amplificateur opérationnel comportant une seconde boucle de contre-réaction, alimenté au moins en partie par les tensions d'alimentation générées par la pompe de charge, et dont la seconde sortie est reliée à la seconde grille du second transistor.

Ce second amplificateur est monté en comparateur d'une seconde source de tension présentant la même tension de référence prédéterminée et d'une seconde différence de tension entre celle des tensions appliquées présente sur la deuxième borne de raccordement et celle des tensions appliquées présente sur la troisième borne de raccordement.

Dans ce mode de réalisation de l'invention, la pompe de charges est de préférence alimentée, ou non, entre les première et troisième bornes de raccordement en fonction de la valeur moyenne ou de la fréquence de celle des tensions appliquées présente sur la deuxième borne de raccordement.

Alternativement ou simultanément, la deuxième borne de raccordement de l'élément est avantageusement reliée à la troisième borne de raccordement par un circuit de shunt, comprenant une résistance, quand la fréquence de celle des tensions appliquées présente sur la deuxième borne est nulle.

L'élément de pont redresseur synchrone selon l'invention comporte de préférence une borne de raccordement supplémentaire présentant un signal de diagnostic indiquant une défaillance de cet élément.

Conformément au but de l'invention, l'élément de pont redresseur synchrone est réalisé fort avantageusement sous la forme d'un boîtier surmoulé, présentant un fond métallique relié à la deuxième ou troisième borne de raccordement, et une, ou des grilles de connexion isolées reliées à la première borne de raccordement et supportant le premier transistor, ou aux première et deuxième bornes de raccordement et supportant les premier et second transistors.

De préférence, le premier amplificateur et/ou le second amplificateur, la pompe de charges, et/ou l'oscillateur, et/ou le circuit de mise en veille, et/ou le circuit de shunt, et/ou le circuit de diagnostic sont réalisés sous la forme d'un ou de plusieurs circuits ASIC (type de circuit intégré à application spécifique), préférentiellement un seul circuit ASIC.

L'invention concerne aussi un pont redresseur synchrone remarquable en qu'il est constitué par un ou plusieurs éléments de pont redresseur ayant les caractéristiques ci-dessus, ainsi qu'une machine électrique tournante de type génératrice incorporant au moins un tel pont redresseur synchrone.

Ces quelques spécifications essentielles auront rendu évidents pour l'homme de métier les avantages apportés par l'élément de pont redresseur synchrone, le pont redresseur correspondant et son utilisation par rapport à l'état de la technique antérieur.

Les spécifications détaillées de l'invention sont données dans la description qui suit en liaison avec les dessins ci-annexés. Il est à noter que ces dessins n'ont d'autre but que d'illustrer le texte de la description et ne constituent en aucune sorte une limitation de la portée de l'invention.

### BREVE DESCRIPTION DES DESSINS

La Figure 1 montre le schéma de principe classique d'un pont redresseur triphasé asynchrone à diodes connu de l'état de la technique.
La Figure 2 montre le schéma de principe d'un pont redresseur synchrone triphasé utilisant des transistors en commutation connu de l'état de la technique.
La Figure 3 montre le schéma de principe d'un dispositif de commande d'un transistor MOS connu de l'état de la technique, et déjà mis en oeuvre dans un pont de conversion électrique.
La Figure 4 représente le schéma synoptique d'un premier mode de réalisation préféré de l'élément de pont redresseur synchrone selon l'invention.
La Figure 5 représente le schéma synoptique d'un second mode de réalisation préféré de l'élément de pont redresseur synchrone selon l'invention.
La Figure 6 représente le schéma de principe du second mode de réalisation préféré de l'élément de pont redresseur synchrone selon l'invention.
La Figure 7 montre schématiquement la structure d'un circuit intégré correspondant au second mode de réalisation préféré de l'invention.
La Figure 8 est une vue schématique d'une machine électrique tournante triphasée incorporant un pont redresseur constitué de trois éléments de pont selon le second mode de réalisation de l'invention.

### DESCRIPTION DES MODES DE REALISATION PREFERES DE L'INVENTION

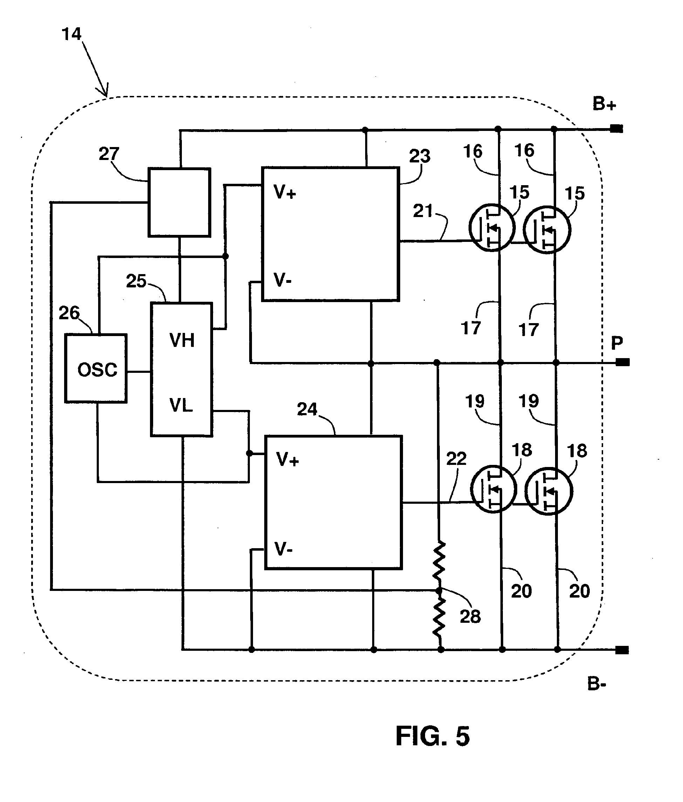

Le rappel des grandes étapes de l'évolution de l'état de la technique des ponts redresseurs illustrées par les dispositifs schématisés sur les Figures 1, 2 et 3 permettra de bien comprendre l'apport de l'invention représentée de manière synoptique sur les Figures 4 et 5.

La Figure 1 montre un pont redresseur triphasé 1 produisant une tension continue positive B+ par rapport à la masse à partir des tensions alternatives aux bornes P1,P2,P3 des enroulements 2 d'un alternateur triphasé.

Dans le domaine de l'automobile, l'alternateur fonctionne à basse tension de manière à fournir, après redressement, une tension continue B+ de l'ordre de 14V alimentant la batterie et le réseau de bord. La chute de tension aux bornes des diodes dans le sens passant, de l'ordre de 0,7V, entraîne dans le circuit d'alimentation une importante chute de tension relative de l'ordre de 10%.

Dans le pont redresseur synchrone représenté sur la Figure 2, les diodes 1 du montage précédent sont replacées par des transistors MOSFET canal N 3 fonctionnant en commutation. La très faible résistance des transistors MOSFET 3 à l'état passant n'entraîne dans le circuit des enroulements de phases 2 que des chutes de tension supplémentaires de l'ordre de quelques dizaines de millivolts.

Dans l'étape de l'évolution de la technique illustrée par le dispositif représenté sur la Figure 2, les transistors MOSFET 3 sont commandés en « tout » ou « rien » par des tensions de commutation appliquées sur leurs grilles 4 par des circuits de commande 5 fonctionnant de manière binaire.

L'amélioration suivante a consisté à remplacer les circuits de commande 5 en mode binaire par des circuits de pilotage 6 des transistors MOSFET en mode linéaire, tels que celui représenté sur la Figure 3, de manière, soit à rendre constante la tension Vds entre drain D1 et source S1, soit à minimiser l'accumulation de charges pendant l'état passant.

Pour ce faire, le circuit de pilotage 6 en mode linéaire comprend un amplificateur opérationnel 7 monté en comparateur d'une source de tension de référence Uref et de la tension drain-source Vds, et dont la sortie 8 est reliée par une résistance R" à la grille 9 du MOSFET 10. L'amplificateur opérationnel 7 comporte une boucle de contre-réaction constituée par un circuit RC.

L'amplificateur opérationnel 7 est alimenté par des sources de tension connectées à sa borne d'alimentation positive V+ et à sa borne d'alimentation négative V- ayant des niveaux suffisants, par rapport aux potentiels de drain D1 et de source S1, pour que la tension de sortie commande efficacement la grille 9 du transistor MOSFET canal N 10.

La nécessité de pourvoir les circuits de commande 5 ou de pilotage 6 en alimentations électriques appropriées est précisément l'inconvénient des dispositifs représentés sur les Figures 2 et 3 par rapport au montage de la Figure 1 : les transistors MOSFET 3,10 ne peuvent pas remplacer simplement les diodes redresseuses 1.

Dans un premier mode de réalisation préféré, dont la Figure 4 est un schéma synoptique, l'invention consiste donc à prévoir l'alimentation V+,V-du circuit de pilotage 6 en mode linéaire du transistor MOSFET canal N 10, ou de plusieurs en parallèle, à partir de la tension aux bornes D1,S1 de celui-ci.

Le montage possédant une alimentation autonome, il constitue un élément de pont redresseur synchrone 11 entre une première borne de raccordement D1 et une seconde borne de raccordement S1 qui remplace de manière transparente une diode redresseuse dont l'anode serait la première borne D1, et la cathode la seconde borne S1.

Une pompe de charges 12 en parallèle sur les bornes de raccordement D1, S1 génère les tensions d'alimentation haute VH et basse VL requises par l'amplificateur opérationnel 7 du circuit de pilotage 6.

La pompe de charges 12 est commandée par un oscillateur 13, lui-même alimenté par les tensions VH,VL générées.

Un second mode de réalisation préférée de l'invention est un élément de pont redresseur synchrone 14, dont la Figure 5 donne le schéma synoptique, remplaçant de manière transparente un bras de pont redresseur asynchrone à diodes, tel que celui représenté sur la Figure 1.

L'élément 14 comporte donc trois bornes de raccordement : une première borne de raccordement B+ correspondant au pôle positif du pont redresseur, une deuxième borne P reliée à l'une des phases de l'alternateur, et une troisième borne B- qui est généralement à la masse.

De manière analogue au montage de remplacement d'une diode unique, le montage de remplacement du bras de pont à diode comprend un premier transistor MOSFET canal N 15, ou plusieurs en parallèle, dont le drain 16 est connecté à la première borne de raccordement B+, et dont la source 17 est connectée à la deuxième borne de raccordement P.

Il comprend de plus un second transistor MOSFET canal N 18, ou plusieurs en parallèle, dont le drain 19 est connecté à la deuxième borne de raccordement P, et dont la source 20 est connectée à la troisième borne de raccordement B-.

Les grilles 21, 22 des premier et second transistors MOSFET 15, 18 sont pilotées chacune par un circuit de pilotage 23, 24 tel que celui représenté sur la Figure 3.

Les circuits de pilotage 23, 24 sont alimentés par une pompe de charges 25 générant des tensions d'alimentation haute VH et basse VL à partir de la tension entre la première B+ et troisième borne B-.

La tension d'alimentation haute VH alimente la borne d'alimentation positive V+ du premier circuit de pilotage 23, dont la borne d'alimentation négative V- est connectée à la deuxième borne de raccordement P.

La tension d'alimentation basse VL alimente la borne d'alimentation positive V+ du second circuit de pilotage 24, dont la borne d'alimentation négative V- est connectée à la troisième borne de raccordement B-.

Cette pompe de charges 25 est commandée par un oscillateur 26 alimenté lui-même par les tensions d'alimentation VH, VL générées.

Un circuit de mise en veille 27 de la pompe de charges 25 entre en fonction selon l'amplitude moyenne de la tension prélevée par un pont de résistances 28 entre la deuxième borne de raccordement P, c'est-à-dire la borne de phase, et la troisième borne de raccordement B-, c'est-à-dire, en général, la masse.

Quand l'amplitude moyenne est inférieure à une valeur prédéterminée, le circuit de mise en veille 27 isole la pompe de charges 25 de la première borne B+.

Cette protection en sous-tension permet de désactiver le redressement synchrone si la tension aux bornes de l'alternateur ne suffit pas à assurer une commande correcte des transistors 15,18, ce qui pourrait entraîner leur destruction.

L'arrêt de la pompe de charges 25 est aussi avantageusement déclenché quand la fréquence de la tension de phase est inférieure à une fréquence minimale.

Dans ce cas, l'élément de pont redresseur synchrone 14 se comporte en pont de diodes classique grâce aux diodes parasites des transistors MOSFET 15,18.

De préférence, les circuits de pilotage 23, 24 des transistors MOSFET assurent la mise à la masse de la deuxième borne de raccordement P, ou borne de phase, par un circuit shunt comprenant une résistance lorsque la fréquence de la tension de phase est nulle, c'est-à-dire que l'alternateur est à l'arrêt.

Une borne de raccordement supplémentaire renvoie un signal de diagnostic indiquant la défaillance de l'élément 14 (qui pourrait entraîner une surchauffe de l'alternateur).

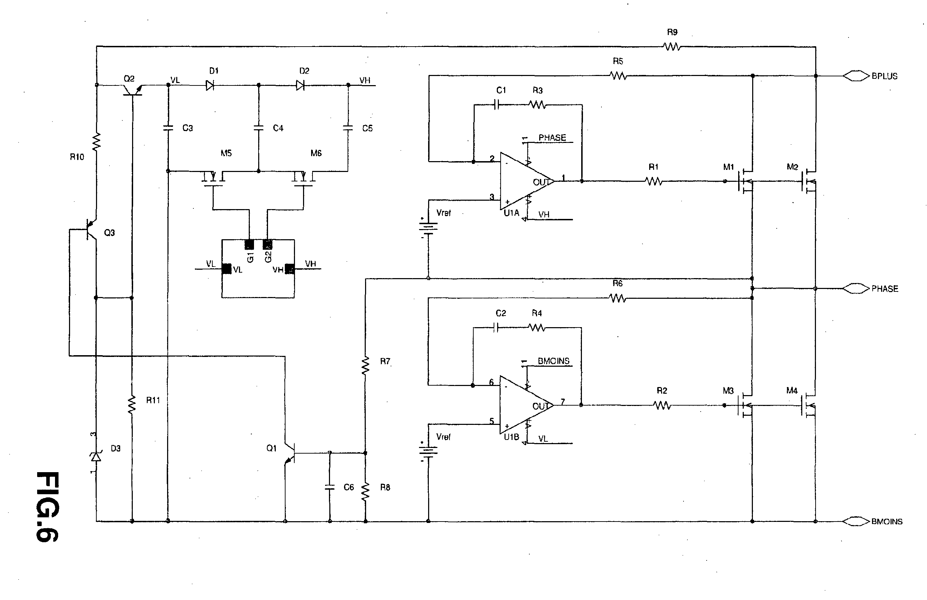

Le schéma de principe de l'élément de pont redresseur synchrone 14 selon le second mode de réalisation préféré de l'invention est donné sur la Figure 6.

Le détail des circuits de pilotage 23,24, connu en soi, n'appelle pas de commentaire particulier.

La pompe de charges 25 générant les tensions d'alimentation VH et VL comprend deux diodes D1,D2 et trois condensateurs C3,C4,C5 dont la charge en parallèle et la décharge en série est contrôlée par deux transistors MOSFET canal N M5,M6, dont les grilles sont pilotées par les sorties G1,G2 de l'oscillateur 26.

Le circuit de mise en veille 27 comprend un transistor NPN Q2 jouant le rôle d'interrupteur dans le circuit d'alimentation de la pompe de charges 25 entre la première borne de raccordement B+ et la troisième borne de raccordement B- de l'élément de pont redresseur synchrone 14.

La base de ce transistor Q2 est commandée par la tension prélevée entre la borne de phase P et la troisième borne B- par le pont de résistances 28 après filtrage par une capacité C6 et amplification en cascade par un transistor NPN Q1 suivi d'un transistor PNP Q3.

L'élément de pont redresseur synchrone selon l'invention est de préférence réalisé sous la forme d'un boîtier surmoulé en technologie IML (acronyme anglais de « Insulated Molded Leadframe », c'est-à-dire « Grille de connexion Moulée Isolée »).

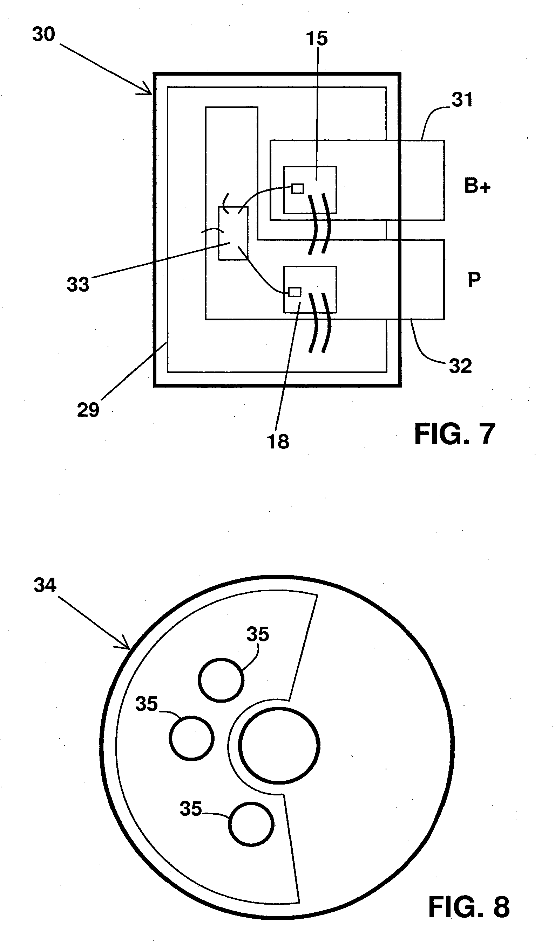

La Figure 7 représente schématiquement un exemple d'intégration en technologie IML de l'élément de pont redresseur synchrone 14 selon le second mode de réalisation de l'invention, c'est-à-dire un bras de pont redresseur.

Le fond métallique 29 du boîtier surmoulé 30 constitue la troisième borne de raccordement B- de l'élément 14 et assure la dissipation thermique.

Les première et seconde grilles de connexion 31,32 correspondant respectivement aux première et deuxième bornes de raccordement B+,P de l'élément 14 sont collées sur le fond métallique 29 à l'aide de colle thermiquement conductrice mais électriquement isolante (silicone à billes de verre par exemple).

La première grille de connexion 31 de forme allongée, sensiblement rectangulaire, supporte le premier transistor MOSFET 15 (ou plusieurs en parallèle).

La seconde grille de connexion 32, sensiblement en forme de L, juxtaposée à la première grille de connexion 31, supporte le second transistor MOSFET 18 (ou plusieurs en parallèle), ainsi qu'un circuit ASIC 33 (acronyme anglais de « Application Specific Integrated Circuit », c'est-à-dire « Circuit Intégré à Application Spécifique»).

Le circuit ASIC 33 comprend la pompe de charge 25, l'oscillateur 26, le circuit de mise en veille 27 et les circuits de pilotage 23,24 des MOSFETs 15,18.

Il comprend aussi de préférence le circuit de shunt et le circuit de diagnostic de l'élément 14.

L'intégration de l'élément de pont redresseur synchrone 14 dans module autonome 30 permet son encapsulation en élément bouton de la même manière qu'une paire de diodes constituant un bras de pont redresseur classique.

De ce fait, la vue de la Figure 8, où l'homme de métier croirait reconnaître facilement la vue d'une face d'un alternateur triphasé 34 présentant trois éléments boutons 35 contenant classiquement chacun un bras de pont redresseur à diode, est un exemple d'utilisation de l'élément de pont redresseur synchrone selon l'invention : le remplacement des anciens éléments boutons à diodes sur les alternateurs 34 par de nouveaux éléments 35 à MOSFETs est totalement transparente.

Comme il va de soi l'invention ne se limite pas aux seuls modes d'exécution préférentiels décrits ci-dessus, concernant l'intégration d'un circuit équivalent à une ou deux diodes redresseuses.

Une description analogue pourrait porter sur des éléments de pont redresseur synchrone équivalents à un nombre de diodes supérieur à deux.

De plus, les types particuliers des éléments à semi-conducteur précisés ci-dessus, c'est-à-dire MOSFET canal N, transistors PNP ou NPN, ne sont donnés qu'à titre d'exemple.

L'invention embrasse toutes les variantes possibles de réalisation mettant en oeuvre tout autre type d'élément à semi-conducteur présentant des fonctionnalités équivalentes à ceux cités, au prix éventuellement d'une permutation des polarités des tensions appliquées, dans la mesure où ces variantes restent dans le cadre défini par les revendications ci-après.

## Revendications

1. Elément de pont redresseur synchrone (11,14) présentant au moins une première borne de raccordement (D1,B+), et au moins une deuxième borne de raccordement (S1,P), ledit élément (11,14) étant du type de ceux comprenant au moins un premier transistor à effet de champ (10,15) dont la première source (10a,16) et le premier drain (10b,17) sont reliés respectivement auxdites au moins première et deuxième bornes (D1,B+;S1,P), et au moins un premier amplificateur opérationnel (7,U1A), monté en comparateur d'au moins une première source de tension (Uref,Vref) ayant une tension de référence prédéterminée et d'au moins une première différence de tension (Vds) entre des tensions appliquées auxdites au moins première et deuxième bornes (D1,B+;S1,P), et dont la première sortie (8) est reliée à la première grille (9,21) dudit au moins premier transistor (10,15), et ledit élément (11,14) comporte une pompe de charges (12,25) produisant au moins l'une des tensions d'alimentation (VH,VL) dudit premier amplificateur (7,U1A) à partir desdites tensions appliquées, **caractérisé en ce que** ledit au moins un premier amplificateur comporte une première boucle de contre-réaction (R,C;R3,C1) et ledit élément comprend un circuit de mise en veille (27) de ladite pompe de charge (25) quand la fréquence ou l'amplitude moyenne d'au moins l'une desdites tensions appliquées est inférieure à une valeur prédéterminée.

2. Elément de pont redresseur synchrone (11,14) selon la revendication 1, **caractérisé en ce que** ladite pompe de charges (12,25) est commandée par un oscillateur (13,26) alimenté par ladite pompe de charge (12,25).

3. Elément de pont redresseur synchrone (11,14) selon la revendication 1 ou 2 précédente, **caractérisé en ce qu'**il comprend au moins un second transistor à effet de champ (18) dont la seconde source (19) et le second drain (20) sont reliés respectivement à ladite deuxième borne (P) et à une troisième borne de raccordement (B-), et un second amplificateur opérationnel (U1B), alimenté au moins en partie par les tensions d'alimentation (VH,VL) générées par ladite pompe de charges (25), comportant une seconde boucle de contre-réaction (R4,C2), monté en comparateur d'une seconde source de tension (Vref) présentant ladite tension de référence prédéterminée et d'une seconde différence de tension entre celle desdites tensions appliquées présente sur ladite deuxième borne (P) et celle desdites tensions appliquées présente sur ladite troisième borne (B-), et dont la seconde sortie est reliée à la seconde grille (22) dudit second transistor (18).

4. Elément de pont redresseur synchrone (14) selon la revendication 3, **caractérisé en ce que** ladite pompe de charges (25) est alimentée, ou non, entre lesdites première et troisième bornes (B+,B-) en fonction de la valeur moyenne ou de la fréquence de celle desdites tensions appliquées présente sur ladite deuxième borne (P).

5. Elément de pont redresseur synchrone (14) selon la revendication 3, **caractérisé en ce que** ladite deuxième borne (P) est reliée à ladite troisième borne (B-) par un circuit de shunt, comprenant une résistance, quand la fréquence de celle desdites tensions appliquées présente sur ladite deuxième borne (P) est nulle.

6. Elément de pont redresseur synchrone selon l'une quelconque des revendications 1 à 5, **caractérisé en ce qu'**il comporte une borne de raccordement supplémentaire présentant un signal de diagnostic indiquant une défaillance dudit élément.

7. Elément de pont redresseur synchrone (11,14) selon l'une quelconque des revendications 1 à 6, **caractérisé en ce qu'**il est réalisé sous la forme d'un boîtier surmoulé (30), présentant un fond métallique (29) relié à ladite deuxième borne (S1) ou ladite troisième borne (B-), et une, ou des grilles de connexion isolées (31,32) reliées à ladite première borne (D1), et supportant ledit premier transistor (10), ou auxdites première et deuxième bornes (B+,P), et supportant lesdits premier et second transistors (15,18).

8. Elément de pont redresseur synchrone (11,14) selon l'une quelconque des revendications 1 à 7, **caractérisé en ce que** ledit premier amplificateur (7,U1A) et/ou ledit second amplificateur (U1B), ladite pompe de charges (12,25), et/ou ledit oscillateur (13,26), et/ou ledit circuit de mise en veille (27), et/ou ledit circuit de shunt, et/ou ledit circuit de diagnostic sont réalisés sous la forme d'un ou de plusieurs circuits ASIC (33), de préférence un seul circuit ASIC (33).

9. Pont redresseur synchrone constitué par un ou plusieurs éléments de pont redresseur (11,14) selon l'une quelconque des revendications 1 à 8 précédentes.

10. Machine électrique tournante (34) de type génératrice incorporant au moins un pont redresseur synchrone selon la revendication 9 précédente.

## Patentansprüche

1. Glied für eine Synchrongleichrichterbrücke (11, 14), umfassend mindestens eine erste Anschlussklemme (D1, B+) und mindestens eine zweite Anschlussklemme (S1, P), wobei das Glied (11, 14) vom Typ jener ist, welche mindestens einen ersten Feldeffekttransistor (10, 15), dessen erste Quelle (10a, 16) und erster Drain (10b, 17) jeweils an die mindestens eine erste und zweite Klemme (D1, B+; S1, P) angeschlossen sind, und mindestens einen ersten Betriebsverstärker (7, U1A) umfassen, der als Komparator mindestens einer ersten Spannungsquelle (Uref, Vref) mit einer vorbestimmten Referenzspannung und mindestens einer ersten Spannungsdifferenz (Vds) zwischen Spannungen, die an die mindestens erste und zweite Klemme (D1, B+; S1, P) angelegt werden, montiert ist, und dessen erster Ausgang (8) mit dem ersten Gate (9, 21) des mindestens ersten Transistors (10, 15) verbunden ist, und wobei das Glied (11, 14) eine Lastenpumpe (12, 25) umfasst, die mindestens eine der Versorgungsspannungen (VH, VL) des ersten Verstärkers (7, U1A) aus den angelegten Spannungen erzeugt, **dadurch gekennzeichnet, dass** der mindestens eine erste Verstärker eine erste Gegenreaktionsschleife (R, C; R3, C1) umfasst, und dass das Glied eine Alarmschaltung (27) der Lastenpumpe (25) umfasst, wenn die Frequenz oder die durchschnittliche Amplitude mindestens einer der angelegten Spannungen kleiner als ein vorbestimmter Wert ist.

2. Glied für eine Synchrongleichrichterbrücke (11, 14) nach Anspruch 1, **dadurch gekennzeichnet, dass** die Lastenpumpe (12, 25) von einem Oszillator (13, 26) gesteuert wird, der von der Lastenpumpe (12, 25) versorgt wird.

3. Glied für eine Synchrongleichrichterbrücke (11, 14) nach dem vorhergehenden Anspruch 1 oder 2, **dadurch gekennzeichnet, dass** es mindestens einen zweiten Feldeffekttransistor (18), dessen zweite Quelle (19) und zweiter Drain (20) an die zweite Klemme (P) bzw. eine dritte Anschlussklemme (B-) angeschlossen sind, und einen zweiten Betriebsverstärker (U1B) umfasst, der zumindest teilweise mit den Versorgungsspannungen (VH, VL) versorgt wird, die von der Lastenpumpe (25) erzeugt werden, umfassend eine zweite Gegenreaktionsschleife (R4, C2), die als Komparator einer zweiten Spannungsquelle (Vref), die die vorbestimmte Referenzspannung aufweist, und einer zweiten Spannungsdifferenz zwischen jener der angelegten Spannungen, die an der zweiten Klemme (P) vorhanden ist, und jener der angelegten Spannungen, die an der dritten Klemme (B-) vorhanden ist, montiert ist und dessen zweiter Ausgang mit dem zweiten Gate (22) des zweiten Transistors (18) verbunden ist.

4. Glied für eine Synchrongleichrichterbrücke (14) nach Anspruch 3, **dadurch gekennzeichnet, dass** die Lastenpumpe (25) zwischen der ersten und dritten Klemme (B+, B-) in Abhängigkeit vom Durchschnittswert oder der Frequenz jener der angelegten Spannungen, die an der zweiten Klemme (P) vorhanden ist, versorgt wird oder nicht.

5. Glied für eine Synchrongleichrichterbrücke (14) nach Anspruch 3, **dadurch gekennzeichnet, dass** die zweite Klemme (P) mit der dritten Klemme (B-) durch eine Shunt-Schaltung, umfassend einen Widerstand, verbunden ist, wenn die Frequenz jener der angelegten Spannungen, die an der zweiten Klemme (P) vorhanden ist, gleich null ist.

6. Glied für eine Synchrongleichrichterbrücke nach einem der Ansprüche 1 bis 5, **dadurch gekennzeichnet, dass** es eine zusätzliche Anschlussklemme umfasst, die ein Diagnosesignal aufweist, das einen Fehler des Gliedes anzeigt.

7. Glied für eine Synchrongleichrichterbrücke (11, 14) nach einem der Ansprüche 1 bis 6, **dadurch gekennzeichnet, dass** es in Form eines aufgeformten Gehäuses (30) hergestellt ist, umfassend einen metallischen Boden (29), der mit der zweiten Klemme (S1) oder der dritten Klemme (B-) verbunden ist, und ein oder mehrere isolierte Anschlussgates (31, 32), die mit der ersten Klemme (D1) verbunden sind und den ersten Transistor (10) tragen, oder mit der ersten und zweiten Klemme (B+, P) verbunden sind und den ersten und zweiten Transistor (15, 18) tragen.

8. Glied für eine Synchrongleichrichterbrücke (11, 14) nach einem der Ansprüche 1 bis 7, **dadurch gekennzeichnet, dass** der erste Verstärker (7, U1A) und/oder der zweite Verstärker (U1B), die Lastenpumpe (12, 25) und/oder der Oszillator (13, 26) und/oder die Alarmschaltung (27) und/oder die Shunt-Schaltung und/oder die Diagnoseschaltung in Form einer oder mehrerer ASIC-Schaltungen (33), vorzugsweise einer einzigen ASIC-Schaltung (33), ausgeführt sind.

9. Synchrongleichrichterbrücke, bestehend aus einem oder mehreren Gliedern für eine Gleichrichterbrücke (11, 14) nach einem der vorhergehenden Ansprüche 1 bis 8.

10. Elektrische Drehmaschine (34) vom Typ Generator, umfassend mindestens eine Synchrongleichrichterbrücke nach dem vorhergehenden Anspruch 9.

## Claims

1. Member for a synchronous rectifier bridge (11, 14) with at least one first connection terminal (D1, B+), and at least one second connection terminal (S1, P), said member (11, 14) being of the type of those comprising at least one first field effect transistor (10, 15) whose first source (10a, 16) and first drain (10b, 17) are linked to said at least first and second terminals (D1, B+; S1, P) respectively, and at least one first operational amplifier (7, U1A), mounted as a comparator of at least one first voltage source (Uref, Vref) having a predetermined reference voltage and of at least one first voltage difference (Vds) between voltages applied to said at least first and second terminals (D1, B+; S1, P), and whose first output (8) is linked to the first gate (9, 21) of said at least first transistor (10, 15), and said member (11, 14) includes a charge pump (12, 25) producing at least one of the supply voltages (VH, VL) of said first amplifier (7, U1A) from said applied voltages, **characterized in that** said at least one first amplifier includes a first feedback loop (R,C;R3,C1) and said member comprises a circuit (27) for putting said charge pump (25) into standby mode when the frequency or the mean amplitude of at least one of said applied voltages is below a predetermined value.

2. Member for a synchronous rectifier bridge (11, 14) according to Claim 1, **characterized in that** said charge pump (12, 25) is controlled by an oscillator (13, 26) powered by said charge pump (12, 25).

3. Member for a synchronous rectifier bridge (11, 14) according to the preceding Claim 1 or 2, **characterized in that** it comprises at least one second field effect transistor (18) whose second source (19) and second drain (20) are linked to said second terminal (P) and to a third connection terminal (B-) respectively, and a second operational amplifier (U1B), at least partly powered by the supply voltages (VH, VL) generated by said charge pump (25), including a second feedback loop (R4, C2), mounted as a comparator of a second voltage source (Vref) exhibiting said predetermined reference voltage and of a second voltage difference between that of said applied voltages present on said second terminal (P) and that of said applied voltages present on said third terminal (B-), and whose second output is linked to the second gate (22) of said second transistor (18).

4. Member for a synchronous rectifier bridge (14) according to Claim 3, **characterized in that** said charge pump (25) is powered, or otherwise, between said first and third terminals (B+,B-), as a function of the mean value or of the frequency of that of said applied voltages present on said second terminal (P).

5. Member for a synchronous rectifier bridge (14) according to Claim 3, **characterized in that** said second terminal (P) is linked to said third terminal (B-) by a shunt circuit, comprising a resistor, when the frequency of that of said applied voltages present on said second terminal (P) is nil.

6. Member for a synchronous rectifier bridge according to any of Claims 1 to 5, **characterized in that** it includes an additional connection terminal exhibiting a diagnostic signal indicating a failure of said member.

7. Member for a synchronous rectifier bridge (11, 14) according to any one of Claims 1 to 6, **characterized in that** it is produced in the form of an overmoulded housing (30), having a metallic bottom (29) linked to said second terminal (S1) or said third terminal (B-), and one, or several insulated connecting grids (31, 32) linked to said first terminal (D1), and supporting said first transistor (10), or to said first and second terminals (B+, P), and supporting said first and second transistors (15, 18).

8. Member for a synchronous rectifier bridge (11, 14) according to any one of Claims 1 to 7, **characterized in that** said first amplifier (7, U1A) and/or said second amplifier (U1B), said charge pump (12, 25), and/or said oscillator (13, 26) and/or said standby circuit (27), and/or said shunt circuit, and/or said diagnostic circuit are made in the form of one or more ASIC circuits (33), preferably a single ASIC circuit (33).

9. Synchronous rectifier bridge composed of one or more rectifier bridge members (11, 14) according to any one of the preceding Claims 1 to 8.

10. Rotary electric machine (34) of generator type incorporating at least one synchronous rectifier bridge according to the preceding Claim 9.
